Europäisches Patentamt

European Patent Office

Office européen des brevets

(11) Publication number: **0 245 179 B1**

## EUROPEAN PATENT SPECIFICATION

(45) Date of publication of patent specification: **30.12.92**

(51) Int. Cl.5: **H01L 23/48**, H01L 23/50, H01L 23/32

(21) Application number: **87401034.1**

(22) Date of filing: **06.05.87**

(54) **System for detachably mounting semiconductors on conductor substrate.**

(30) Priority: **07.05.86 US 860725**

(43) Date of publication of application:
**11.11.87 Bulletin 87/46**

(45) Publication of the grant of the patent:
**30.12.92 Bulletin 92/53**

(84) Designated Contracting States:
**AT BE CH DE ES FR GB GR IT LI LU NL SE**

(56) References cited:
**WO-A-85/00467**
**US-A- 4 667 219**

**IBM TECHNICAL DISCLOSURE BULLETIN, vol. 27, no. 8, January 1985, page 4855, New York, US; K. HINRICHSMEYER et al.: "Solder-filled elastomeric spacer"**

**IDEM**

**IBM TECHNICAL DISCLOSURE BULLETIN, vol. 25, no. 4, September 1982, pages 1801-1802, New York, US; E.W. NEUMANN et al.: "Electrically conductive array in an elastomeric material"**

(73) Proprietor: **DIGITAL EOUIPMENT CORPORA-TION**
**146 Main Street**
**Maynard, MA 01754(US)**

(72) Inventor: **Lee, James C.K.**
**28446 Christopher Lane**
**Los Altos Hills California 94022(US)**
Inventor: **Amdahl, Gene M.**
**165 Patricia Avenue**
**Atherton California 94025(US)**
Inventor: **Beck, Richard**
**10182 Parish Place**
**Cupertino California 95014(US)**
Inventor: **Lee, Chune**
**1836 Cabrillo Street**
**San Francisco California 94121(US)**
Inventor: **Hu, Edward**
**648 Kodiak Court = 4**
**Sunnyvale California 94087(US)**

(74) Representative: **Mongrédien, André et al**
**c/o SOCIETE DE PROTECTION DES INVEN-TIONS 25, rue de Ponthieu**
**F-75008 Paris(FR)**

## Description

### BACKGROUND OF THE INVENTION

#### 1. Field of the Invention

The present invention relates generally to systems for mounting semiconductor dies on conductor substrates, and more particularly to a system which provides for detachably mounting such semiconductor dies without soldering by interposing a resilient anisotropic conductor pad between the semiconductor die and the conductor substrate.

Integrated circuits are typically fabricated on relatively large silicon wafers which are then divided into a plurality of individual circuits, referred to as dies or chips. The individual dies may then be packaged in a variety of ways, including the familiar dual-in-line package, referred to as the DIP, where the die is encapsulated in plastic or ceramic. The individual DIPs may then be mounted and interconnected on printed circuit boards in order to build up the desired circuitry. Although workable, the use of discrete packages, such as DIPs, can result in unacceptable signal propagation delay time between the separated integrated circuits.

An approach which has been developed in order to reduce such signal propagation delay time involves mounting a plurality of discrete dies in a common enclosure on a single conductor substrate, typically a multilayer ceramic substrate. The dies are usually soldered directly to the conductor substrate and may be spaced together very closely in order to reduce the propagation delay time. The use of a common enclosure avoids the necessity of individually packaging the chips for protection.

The use of such multichip modules, however, suffers from a number of problems. It is desirable to have the module as small as possible in order to reduce the signal propagation delay as much as possible. The small module size makes it very difficult to locate and attach the individual dies. Moreover, the large number of dies in a single module greatly increases the likelihood of failure of the module since the chance of at least one die failing is greatly increased. Since the modules must be tested after assembly, the failure of a single die necessitates either discarding the entire module, which can be prohibitively expensive, or detaching and replacing the die or dies which have failed. Detaching the die can be very difficult since in most cases it will have been soldered to the conductor substrate. The problem is exacerbated if, as is frequently the case, the die has also been soldered to a heat sink to enhance heat dissipation.

For the above reasons, it would be desirable to provide alternate systems for the high density mounting of a plurality of semiconductor dies on a single conductor substrate. It would be particularly desirable to provide such systems which allow for detachably mounting the dies on the substrate without solder so that the dies may be easily removed from the substrate in the event of failure. The system should also provide for adequate heat dissipation without the need to solder or otherwise attach the dies to a heat sink, and should additionally provide for a minimum signal propagation delay time between the dies and the conductor substrate. Also, the electrical connections between the dies and the substrate should have a low resistance, and allow for differential thermal expansion between the dies and the substrate which is a particular problem with larger semiconductor dies.

#### 2. Description of the Relevant Art

Modules for mounting a plurality of semiconductor dies on a common conductor substrate are described in IBM Technical Disclosure Bulletin Vol. 13, page 58; Vol. 19, pages 1270-1272; and Vol. 20, pages 3919-3920.

IBM Technical Disclosure Bulletin Vol. 25, pages 1801-1802, discloses an elastomeric layer having widely spaced, discrete spring elements embedded therein. The elastomeric layer is interposed between a chip carrier and a pin carrier to provide for electrical connection.

Elastomeric, anisotropic conductors are described in U.S. Patent Nos 4,003,621; 3,982,320, and 3,862,790.

The reference U.S. Patent N° 3,982,320 discloses a method of making islands of electrically conductive, elastomeric resin dispersed in a non-conductive elastomeric resin to form an electrical connection between two or more sets of spaced electrical conductors.

### SUMMARY OF THE INVENTION

The present invention is a system for the detachable surface mounting of semiconductor dies on conductor substrates. The system allows for high density packing of a plurality of individual dies on a commun conductor substrate in order to reduce the package size and minimize the signal propagation delay time between the dies. The system eliminates the need for solder connecting the dies to the substrate, and thus allows for disassembly and replacement of defective chips within the system and minimizes damage to the chips from the soldering operation. The system provides for low resistance contacts between the dies and the conductor board, and can provide for enhanced heat dissipation when desired.

In particular, the invention relates to a semiconductor die mounting system as defined in claim 1.

The system of the present invention is useful for mounting semiconductor dies of the type having a plurality of signal, power, and/or ground contacts formed on one face thereof. Such contacts are usually arranged in a two-dimensional array extending across the face, but may be arranged peripherally. The conductor substrate, which may be any conventional conductor board, including ceramic substrates and printed circuit boards, will have a plurality of surface contacts arranged in a pattern corresponding at least partly to the pattern of contacts on the semiconductor dies. Interconnection between the dies and the conductor substrate is effected by a resilient, anisotropic conductor pad comprising a plurality of discrete conductive elements embedded in an elastomeric matrix. By spacing the conductors sufficiently closely, electrical conduction between contacts located on opposite sides of the pad is assured. In this way, alignment of the conductor pad is not necessary, so long as the semiconductor die and the conductor substrate are themselves in proper alignment.

In the inventive embodiment, alignment between the dies and the conductor substrate is achieved using a nest plate having a plurality of apertures. The nest plate is mounted on the conductor substrate, and the conductor pads and semiconductor dies are placed in the apertures which are located to assure proper alignment. A cover is then placed over the nest plate to compress the semiconductor die against the resilient conductor pad in order to establish low resistance electrical conduction. The cover is a heat sink, and a second resilient conductor pad is interposed between the upper face of the semiconductor die and the heat sink. The resilient pad helps evenly distribute downward force on the semiconductor die, and the metal conductors in the pad provide for enhanced thermal dissipation from the die to the heat sink.

## BRIEF DESCRIPTION OF THE DRAWINGS

Fig. 1 illustrates a resilient anisotropic conductor pad useful in the mounting system of the present invention.

Fig. 2 is a detailed cross-sectional view illustrating the resilient anisotropic conductor pad of the present invention interposed between a semiconductor die and a conductor substrate.

Fig. 3 is an exploded view of the multiple die mounting system of the present invention, with portions broken away.

Fig. 4 illustrates the assembled mounting system of Fig. 3.

Fig. 5 is an alternate embodiment of the mounting system of the present invention adapted for surface mounting on a printed circuit board.

Fig. 6 is a second alternate embodiment of the mounting system of the present invention where semiconductor dies are mounted directly on opposite sides of a printed circuit board.

## DESCRIPTION OF THE PREFERRED EMBODIMENTS

According to the present invention, semiconductor dies are detachably surface mounted on conductor substrates by interposing resilient, anisotropic conductor pads therebetween. The conductor pads provide for electrical conduction between contacts formed on one face of the chip and corresponding contacts formed on one face of the substrate. The mounting system is particularly useful for mounting a plurality of chips on a common substrate, although it will also find use in mounting single dies on a substrate.

Semiconductor dies are normally formed in multiples on a single silicon wafer on the order of several inches (1 inch = 2,54 cm) in diameter. The wafer is then divided into individual dies, usually on the order of 50 square millimeters or smaller, and each die will include thousands of individual transistors and other circuit elements. The die may provide memory, logic, or a variety of other useful functions. Of particular interest to the present invention are dies having electrical signal contacts formed on one face thereof. Such contacts will provide for power and ground connections, as well as signal connections. Typically, the contacts will be formed as metal contact pads in a predetermined two-dimensional array extending across the surface of the die. Alternatively, the contact pads may be formed linearly along the periphery of the face. The present invention provides a system for interconnecting such contact pads, including signal, power, and ground contact pads, to corresponding contact pads formed on a connector substrate.

The connector substrate may be any conventional connector substrate, including ceramic substrates, plastic substrates, printed circuit boards, and the like. The connector substrate will normally include internal metal traces defining appropriate conductive pads between preselected locations on the conductor board. For example, a contact pad connected to a semiconductor die may be interconnected with a contact pad on the same semiconductor die, with a contact pad on a different semiconductor die, or with an external contact on the conductor substrate. Such external contacts may be in the form of pins, solder pads, spring connectors, or the like.

The present invention employs a resilient, anisotropic conductor pad as the conductive interface between the semiconductor die and the conductive substrate. Such conductor pads must provide for anisotropic electrical conduction in one direction only, while providing very high resistivity, on the order of $10^{15}$ ohm-cm, in the other two orthogonal directions. In this way, electrical conduction is provided between electrical contacts which are located directly across from each other on opposite sides of the conductor pad, while the contacts are electrically isolated from all other contacts which are not so aligned.

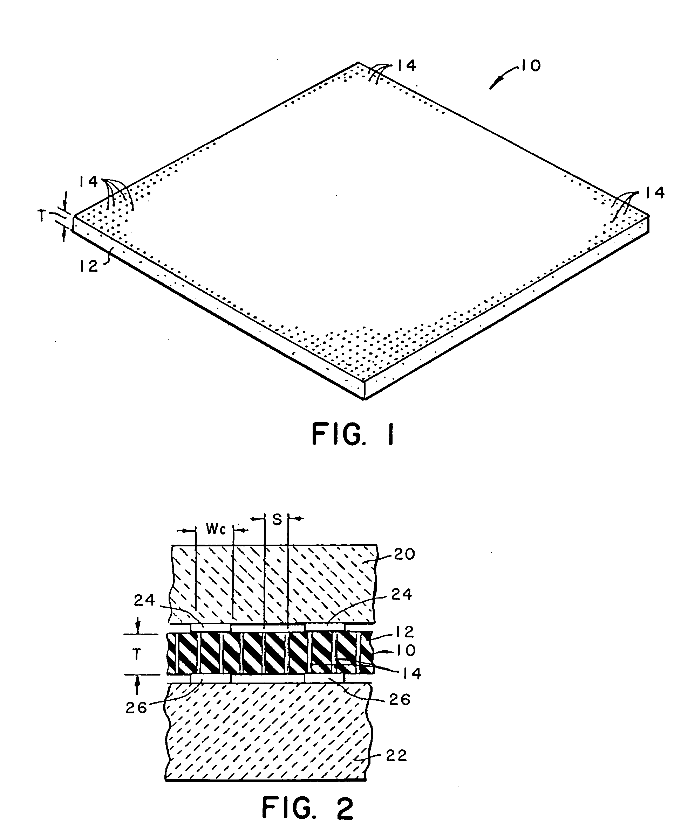

Referring now to Figs. 1 and 2, a resilient, anisotropic conductor pad 10 suitable for use in the present invention will typically comprise an elastomeric matrix 12 having a plurality of discrete conductive elements 14 embedded therein. The conductive elements 14 will be oriented parallel to one another so that contact between any two elements 14 is avoided. In this way, an electrical signal which is introduced to one of the elements 14 will be conducted through the pad 10 by that element only. The elastomeric matrix may be formed from a variety of electrically-insulating elastomers, such as silicone rubbers, including dimethyl, methyl-phenyl, methyl-vinyl, and halogenated siloxanes; butadiene-styrene, butadiene-acrylonitrile, butadiene-isobutylene, and the like.

The conductive elements 14 will usually be conductive metals, such as copper, aluminum, silver, gold, or alloys thereof, although conductive carbon fibers and the like may also find use.

The dimensions of the resilient, anisotropic conductive pad 10 will vary depending on the particular mounting system being constructed. Usually, the thickness T will be made as small as possible consistent with the need to maintain a resilient interface between the semiconductor die and the ceramic substrate. The thickness T will usually be in the range from about 0.01 to 0.30 inches, more usually in the range from 0.03 to 0.15 inches. The peripheral dimensions will frequently correspond to those of the semiconductor die being mounted, although the dimensions may be greater.

Referring now to Fig. 2, the conductor pad 10 is interposed between a semiconductor die 20 and a conductor substrate 22. The semiconductor die 20 includes a plurality of surface contact pads 24 (only two of which are illustrated in Fig. 2) which are disposed directly against contact pad 10, while subtrate 22 includes a plurality of corresponding contact pads 26 which are disposed against the opposite face of the conductive pad 10. The spacing S between adjacent conductors 14 will be selected to be less than the width $W_c$ of the contact pad 24 or 26. In this way, contact between at least one element 14 and each contact pad 24 or 26 is assured. Usually, the spacing S will be selected to be less than half the width $W_c$ of the contact pads 24 and 26 in order to assure that at least 2, and usually 4, conductors 14 will be in contact with each contact pad. In this way, electrical conduction between contact pads 24 on the die 20 and contact pads 26 on the substrate 22 is accomplished so long as the die and the substrate are properly aligned. The alignment of the conductive pad 10 is not critical so long as the spacing of the conductive elements 14 is uniform and sufficiently close.

Suitable anisotropic conductors may be fabricated by a variety of techniques. Suitable techniques are disclosed in U.S. Patent No. 4,003,621. The relevant disclosures of this reference is incorporated herein by reference.

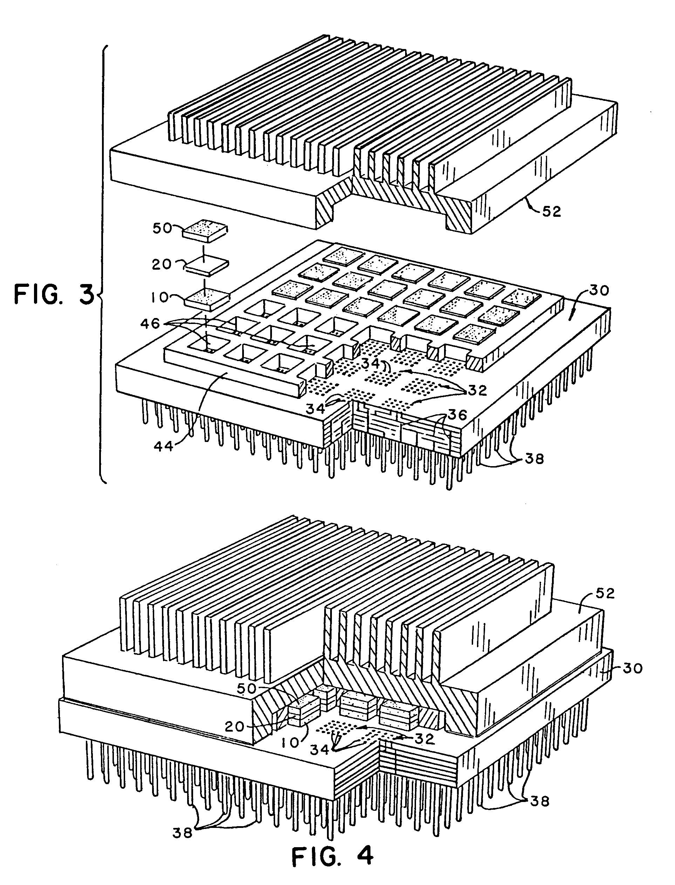

Referring now to Figs. 3 and 4, a specific multiple semiconductor die mounting system constructed in accordance with the principles of the present invention will be described. A ceramic substrate 30 includes a plurality of conductor regions 32 formed on one face thereof. Each conductor region 32 includes a multiplicity of individual contact pads 34. The ceramic substrate 30 further includes internal metallic traces 36 which interconnect the contacts 34 with other contacts 34 and connector pins 38. Connector pins 38 provide for connecting the module with external circuitry by means of a conventional pin receptacle (not shown) which may be mounted on a printed circuit board or other mounting surface.

A nest plate 44 includes a plurality of apertures 46 which are arranged in a pattern corresponding to the pattern of contact regions 32 on the substrate 30. By placing the nest plate over the ceramic substrate 30, the apertures 46 will be aligned with the contact regions 32 and will define receptacles for receiving the resilient conductor pads 10 and semiconductor dies 20. The apertures 46 will be aligned so that the individual contacts 24 (Fig. 2) on the semiconductor die 20 are aligned with corresponding contacts 34 on the substrate 30.

A second anisotropic conductor pad 50 will usually be mounted directly over the semiconductor pad 20. The pad 50 serves two purposes. First, the semiconductor 20 will be interposed between two resilient pads 10 and 50 which will protect the die during the module assembly procedure. Second, by providing the metallic conductors within the pad 50, thermal conduction from the die to a heat sink 52 is facilitated. The heat sink 52 acts as a cover when it is placed over the nest plate 44, compressing the layered structure of the resilient pads 10 and 50 and the semiconductor die 20.

The fully assembled module, with a portion broken away, is illustrated in Fig. 4.

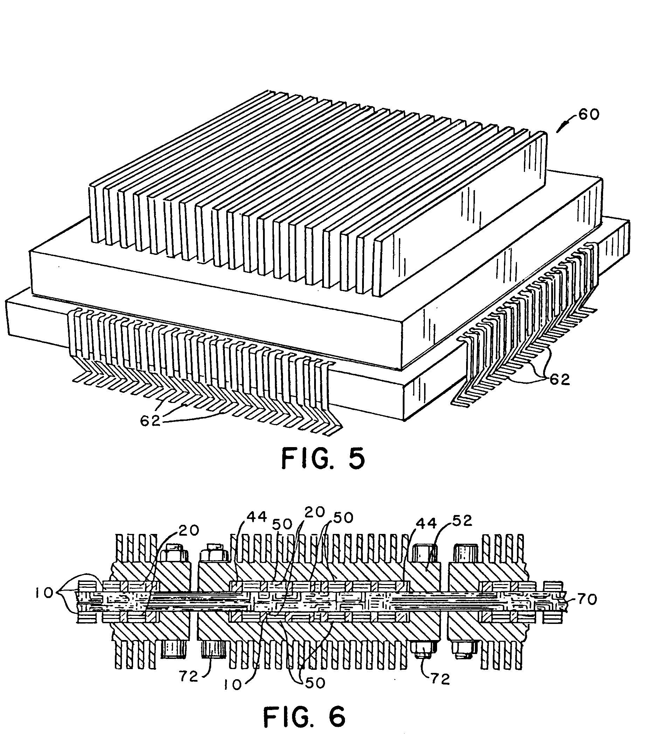

Referring now to Fig. 5, an alternate embodiment of the multisemiconductor module of the present invention is illustrated. The module 60 is identical to the module 30 of Figs. 3 and 4, except that the connector pins 38 are replaced by peripheral solder connectors 62. The solder connectors 62 are conventional and adapted for surface mounting on a printed circuit board or other suitable surface.

Referring now to Fig. 6, the mounting system of the present invention may be used to surface mount semiconductor dies directly on printed circuit boards or ceramic boards without use of discrete mounting modules. A printed circuit board 70 is a multilayer conductive substrate having a plurality of contact regions formed on both surfaces thereof. Contact pads are mounted directly over the contact regions, while semiconductor dies 20 are mounted over the conductor pads 10. Second conductor pads 50 are mounted over the semiconductor dies 20, and the layered structures are aligned in nest plates 44, as described previously. The nest plates 44, in turn, are covered by heat sinks 52 which are detachably secured directly to the printed circuit board 70 by bolts 72.

It will be appreciated that each of the mounting systems described hereinabove may be disassembled without the need to break any solder contacts or other permanent connections made between the semiconductor dies and the conductor substrates. This is a particular advantage since it allows the entire mounting system to be assembled, and fully tested and burned in. If any of the individual semiconductor dies are found to be defective, the mounting system may be disassembled, the defective die removed and replaced. This eliminates the need to dispose of the expensive mounting systems because of the failure of a single component.

## Claims

1. A semiconductor die mounting system comprising:

   a) a substrate (22, 30) with conductors having an array of substrate contacts (26, 34) on a substrate face thereof;

   b) at least one semiconductor die (20) having first and second opposed die faces and a plurality of die contacts (24) on the first die face thereof disposed in alignment with corresponding substrate contacts (26, 34) on the conductor substrate (22, 30);

   c) a resilient conductor pad (10) being disposed between the substrate (22, 30) and the die (20), and comprising a block of resilient insulating material having first and second opposed pad surfaces in contact with the substrate and first die faces, respectively, and a plurality of discrete conductor elements (14) extending between the first and second surfaces thereof in the direction of alignment between the substrate and die contacts (26, 34 and 24) so as to provide electrical conduction between the pad surfaces, adjacent conductive elements being spaced apart by less than the minimum width of the contacts; and

   d) means (44) for holding the semiconductor die and the conductor substrate in contact with the conductor pad so that the resilient pad is compressed therebetween and the corresponding die and substrate contacts are in alignment, the holding means including a nest plate (44) mounted over the conductor substrate for aligning the die and the pad, a cover (52) mounted over the nest plate for compressing the die and conductor pad against the conductor substrate and comprising a heat sink, and a resilient heat-conducting pad (50) disposed between the semiconductor die (20) and the cover (52).

2. A semiconductor die mounting system as in claim 1, further comprising means (72) for sealing the periphery of the cover to the conductor substrate.

3. A semiconductor die mounting system as in claim 1, wherein the conductor substrate (22, 30) is a ceramic substrate.

4. A semiconductor die mounting system as in claim 3, further comprising a pin grid (38) disposed on a face of the ceramic substrate opposite the array of substrate contacts (26, 34).

5. A semiconductor die mounting system as in claim 3, further comprising a plurality of edge connectors (62) formed about the periphery of the ceramic substrate.

6. A semiconductor die mounting system as in claim 1, wherein the substrate includes a plurality of arrays (32) of contacts (34) formed on the substrate face and wherein a separate conductor pad (10) is mounted on each array of contacts.

## Patentansprüche

1. Halbleiterelement-Montierungssystem das aufweist:

   a) ein Substrat (22,30) mit Leitern, das ein Feld aus Substratkontakten (26,34) auf seiner Substratfläche hat;

   b) zumindest ein Halbleiterelement (20) mit ersten und zweiten gegenüberliegenden Elementflächen und einer Vielzahl von Elementkontakten (24) auf seiner ersten Elementfläche, die in Ausrichtung mit entsprechendem Substratkontakten (26, 34) auf dem Leitersubstrat (22, 30) angeordnet sind; c) eine elastische Leiterlage (10), die zwischen dem Substrat (22,30) und dem Element (20) angeordnet ist und einen Block aus elastischem Isolationsmaterial aufweist, der erste und zweite gegenüberliegende Kontaktoberflächen in Kontakt mit dem Substrat bzw. den ersten Elementflächen und eine Vielzahl von diskreten Leiterelementen (14) aufweist, die zwischen seinen ersten und zweiten Oberflächen in der Richtung der Ausrichtung zwischen dem Substrat und den Element-Kontakten (26, 34 und 24) verlaufen, um eine elektrische Leitung zwischen den Kontaktoberflächen zu erzeugen, wobei benachbarte Leiterelemente voneinander um weniger als die Minimalbreite der Kontakte entfernt sind; und d) eine Einrichtung (44) zum Halten des Halbleiterelements und des Leitersubstrats in Kontakt mit der Leiterlage, so daß die elastische Lage dazwischen zusammengedrückt ist und die entsprechenden Element- und Substratkontakte in Ausrichtung sind, wobei die Halteeinrichtung eine Aufnahmeplatte (44), die über dem Leitersubstrat angeordnet ist, zum Ausrichten des Elements und der Lage, eine Abdeckung (52), die über der Aufnahmeplatte angeordnet ist, die das Element und die Leiterlage gegen das Leitersubstrat drückt und eine Wärmesenke aufweist, und eine elastische, wärmeleitende Lage (50) aufweist, die zwischen dem Halbleiterelement (20) und der Abdeckung (52) angeordnet ist.

2. Halbleiterelement-Montierungssystem wie in Anspruch 1, das weiterhin eine Einrichtung (72) zum Abdichten des Randes der Abdeckung gegenüber dem Leitersubstrat aufweist.

3. Halbleiterelement-Montierungssystem wie in Anspruch 1, worin das Leitersubstrat (22, 30) ein keramisches Substrat ist.

4. Halbleiterelement-Montierungssystem wie in Anspruch 3, weiterhin aufweisend ein Anschlußstiftraster (38), das auf einer Fläche des keramischen Substrats gegenüber dem Feld der Substratkontakte (26, 34) angeordnet ist.

5. Halbleiterelement-Montierungssystem wie in Anspruch 3, weiterhin aufweisend eine Vielzahl von Steckerleisten (62), die am Rand des keramischen Substrats ausgebildet sind.

6. Halbleiterelement-Montierungssystem wie in Anspruch 1, worin das Substrat eine Vielzahl von Feldern (32) aus Kontakten (34) aufweist, die auf der Substratfläche ausgebildet sind, und worin eine eigene Leiterlage (10) auf jedem Feld aus Kontakten angeordnet ist.

**Revendications**

1. Système de montage de microplaquettes semi-conductrices comprenant :
a) un substrat (22,30) avec des conducteurs ayant un réseau de contacts (26,34) de substrat, sur une face du substrat;
b) au moins une microplaquette semi-conductrice (20) ayant des première et deuxième faces de microplaquette opposées et une pluralité de contacts (24) de microplaquette sur la première face de la microplaquette, disposés en alignement avec les contacts correspondants (26,34) de substrat sur le substrat conducteur (22,30);
c) une pastille conductrice élastique (10) disposée entre le substrat (22,30) et la microplaquette (20), comprenant un bloc de matériau isolant élastique ayant des première et deuxième faces de pastille opposées, en contact avec la face du substrat et la première face de la microplaquette, respectivement, et une pluralité d'éléments conducteurs discrets (14) s'étendant entre les première et deuxième faces de celle-ci dans la direction de l'alignement entre les contacts (26,34 et 24) de substrat et de microplaquette, de manière à fournir une conduction électrique entre les faces de la pastille, les éléments conducteurs adjacents étant espacés les uns des autres de moins de la largeur minimale des contacts; et
d) des moyens (44) pour maintenir en contact la microplaquette semi-conductrice et le substrat conducteur avec la pastille conductrice, de telle sorte que la pastille élastique est comprimée entre eux et que les contacts correspondants de microplaquette et de substrat sont en alignement, les moyens de maintien incluant une plaque d'emboîtement (44) montée par-dessus le substrat conducteur pour aligner la microplaquette et la pastille, un couvercle (52) monté par-dessus la plaque d'emboîtement pour comprimer la microplaquette et la pastille conductrice contre le substrat conducteur et comprenant un dissipateur de chaleur, et une pastille élastique pour la conduction de la chaleur (50) disposée entre la microplaquette semi-conductrice (20) et le couvercle (52).

2. Système de montage de microplaquettes semi-conductrices selon la revendication 1, comprenant de plus des moyens (72) pour sceller la périphérie du couvercle au substrat conducteur.

3. Système de montage de microplaquettes semi-conductrices selon la revendication 1, dans lequel le substrat conducteur (22,30) est un substrat en céramique.

4. Système de montage de microplaquettes semi-conductrices selon la revendication 3, comprenant de plus une grille d'ergots (38) disposée sur une face du substrat en céramique à l'opposé du réseau de contacts (26,34) de substrat.

5. Système de montage de microplaquettes semi-conductrices selon la revendication 3, comprenant de plus une pluralité de connecteurs de bords (62) formés autour de la périphérie du substrat en céramique.

6. Système de montage de microplaquettes semi-conductrices selon la revendication 1, dans lequel le substrat inclut une pluralité de réseaux (32) de contacts (34) formés sur la face du substrat et dans lequel une pastille conductrice séparée (10) est montée sur chacun des contacts.

FIG. 1

FIG. 2

FIG. 3

FIG. 4

FIG. 5

FIG. 6